# EUROPÄISCHE PATENTSCHRIFT

(11) **EP 1 887 279 B1**
(45) Veröffentlichungstag und Bekanntmachung des Hinweises auf die Patenterteilung: **03.08.2016**
(21) Anmeldenummer: 07015806.8
(22) Anmeldetag: 10.08.2007
(51) Int. Cl.: F21V 21/08, F21S 4/00

(54) **Leuchtgewebe und Verfahren zur dessen Herstellung**
Lighted fabric and method of making the same
Tissu illuminé et méthode de fabrication associée

(30) Priorität: 11.08.2006 DE 102006037878
(43) Veröffentlichungstag der Anmeldung: 13.02.2008
(73) Patentinhaber: Haver & Boecker oHG, 59302 Oelde (DE)
(72) Erfinder: Schumacher, Helmut, 59302 Oelde (DE); Muckermann, Ralf, 48145 Münster (DE); Röttger, Ralf, 59320 Ennigerloh (DE); Pieke, Heribert, 59302 Oelde (DE)
(74) Vertreter: BSB Intellectual Property Law

(56) Entgegenhaltungen:
- WO-A-2006/128447
- DE-U1- 29 717 582
- FR-A- 2 875 580
- JP-A- 10 208 514
- US-A- 5 772 311
- US-A- 5 791 765
- US-A- 5 800 046
- US-B1- 6 260 987
- US-B1- 6 362 801
- US-B1- 6 367 952

## Beschreibung

Die vorliegende Erfindung betrifft ein Leuchtgewebe und ein Verfahren zur dessen Herstellung, sowie ein Verfahren zur Nachrüstung von Drahtgeweben mit Leuchtelementen, um mit einfachen Mitteln aus einem bestehenden Drahtgewebe ein Leuchtgewebe herzustellen.

Es sind im Stand der Technik Drahtgewebe bekannt geworden, die integrierte Lichtquellen beinhalten.

So ist aus der DE 101 27 299 A1 ein Flächengefüge in Form z.B. eines Drahtgewebes bekannt geworden, bei dem ein Materialstrang aus einem Lichtleiter und ein Materialstrang aus einem anderen Material hergestellt ist. Durch die Lichtleiter wird es ermöglicht, am Rand des Gewebes Licht einzukoppeln, das dann über der Länge des Lichtleiters abgegeben wird. Nachteilig daran ist, dass die Lichtabgabe örtlich nicht steuerbar ist, da die Lichtfaser immer über der gesamten Länge Licht abgibt. Ein weiterer Nachteil ist, dass die Lichtfaser bei der Herstellung des Gewebes mit eingewebt werden muss. Ein Nachrüsten bestehender Gewebe ist praktisch nicht möglich.

Aus der EP 1 486 598 A2 ist ein Metallgewebe und ein Verfahren zum Herstellen eines Metallgewebes bekannt geworden, bei dem Lichtleitkörper in Form von Glaskristallen im Gewebe integriert sind. Nachteilig daran ist, dass die Glaskristalle selbst kein Licht abgeben, sondern auf externe Lichtzufuhr angewiesen sind.

Ein weiterer Nachteil ist, dass auch hier praktisch keine Nachrüstung bestehender Gewebe möglich ist.

Mit der US 6,793,360 B2 ist ein beleuchtetes Architekturgewebe bekannt geworden, bei dem Lichtelemente in das Gewebe eingewoben sind. Die Lichtelemente können z.B. optische Fasern sein, die metallische Drähte ersetzen. Auch bei dieser Druckschrift ist es praktisch nicht möglich, ein bestehendes Gewebe nachzurüsten.

Die US-A-5 791 765 beschreibt Lichterketten, die selbst als Netz ausgestaltet sind oder sich für die Verwendung an Drahtnetzen eignen. Dabei werden zu Dekorationszwecken mehrere Lämpchen in eine spezielle Schablonenplatte zum Beispiel in die Form eines Sternes gelegt und mit einem Drahtgewebe abgedeckt. Eine solche Methode ist allerdings sehr unflexibel, da für jede gewünschte Form der Lichterkette eine speziell geformte Schablone benötigt wird. Auch eine Ausgestaltung der Lichterkette als Netz wird gezeigt. Nachteilig bei solchen Lichterketten ist, dass das Anbringen solcher Netze sehr aufwändig ist.

### Auf der Internetseite

"http://www.medienfassade.com/mediamesh.html" ist am 10.08.2006 ein Metallgewebe öffentlich zugänglich beschrieben, bei dem offene Rundprofile in definierten Abständen in die Kette des Gewebes eingeschoben werden. In den offenen Rundprofilen sind Leuchtdioden eingesetzt. Auf der Fläche des Gewebes können Lichtmuster wiedergegeben werden. Schon bei der Herstellung des Gewebes werden Rundprofile mit eingewebt. Nachteilig daran ist, dass der minimale Abstand zweier Rundprofile groß ist. Ein weiterer Nachteil ist, dass ein spezielles Gewebe hergestellt werden muss. Eine Nachrüstung konventioneller Drahtgewebe für den Architekturbereich ist effektiv nicht möglich.

In dem bekannten Stand der Technik ist es sehr aufwandig, Defekte an den Lichtelementen bzw. Lichtleitkörpern zu reparieren. Dazu muss jeweils das Drahtgewebe an z.B. der Fassade des Gebäudes entspannt und gegebenenfalls demontiert werden und anschließend müssen einzelne Lichtelemente ausgetauscht werden, um das jeweils defekte Element auszutauschen.

Mit der US 6,362,801 B1 ist eine Anzeigevorrichtung bekannt geworden, bei an einem flexiblen Netz einzelne Anzeigemodule mit jeweils drei unterschiedlich farbigen Leuchtelementen angebracht werden, die separat ansteuerbar sind, um auf einem einen Anzeigebereich z. B. Fernsehbilder auszugeben. Nachteilig daran ist der große Montageaufwand, wenn auf einer großen Anzeigefläche eine entsprechende Anzahl von Anzeigemodulen angebracht werden soll.

Es ist deshalb die Aufgabe der vorliegenden Erfindung, ein Leuchtgewebe zur Verfügung zu stellen, bei dem es auf relativ einfache Art möglich ist, defekte Leuchtelemente zu reparieren und eine Fassade mit geringem Aufwand nachzurüsten.

Weiterhin soll es relativ einfach möglich sein, ein bestehendes Drahtgewebe nachzurüsten.

Diese Aufgabe wird gelöst durch ein Leuchtgewebe mit den Merkmalen des Anspruchs 1, sowie durch das Verfahren zur Nachrüstung eines Drahtgewebes nach Anspruch 13.

Das erfindungsgemäße Leuchtgewebe nach Anspruch 1 weist wenigstens ein Drahtgewebe und Leuchtelemente auf, wobei das Drahtgewebe Kett- und Schussdrähte aufweist. Die Leuchtelemente des Leuchtgewebes sind in Reihen und Spalten an dem Drahtgewebe vorgesehen und so angeordnet, sodass die Leuchtelemente an einem fertig montierten Drahtgewebe anbringbar sind. Dabei sind wenigstens zwei der Leuchtelemente an einer Stürzeinrichtung angeordnet. Die Leuchtelemente können dann mit der Stützeinrichtung an dem Drahtgewebe angebracht werden. Wenigstens die Mehrzahl der Leuchtelemente ist separat ansteuerbar, um visuelle Bildfolgen auf dem Drahtgewebe auszugeben. Dabei umfasst die Stützeinrichtung eine Schiene.

Das erfindungsgemäße Leuchtgewebe bietet viele Vorteile.

Ein Vorteil ist, dass ein fertig montiertes Drahtgewebe gemäß der Erfindung mit Leuchtelementen nachgerüstet werden kann, sodass bestehende Drahtgewebe im Architekturbereich in Leuchtgewebe umgewandelt werden können.

Ein erheblicher Vorteil ist, dass bei der Reparatur defekter Leuchtelemente nicht erst das ganze Drahtgewebe entspannt oder demontiert werden muss, um die Reparatur durchzuführen.

Außerdem kann bei der Herstellung des Leuchtgewebes das Drahtgewebe auf eine konventionelle Art und Weise hergestellt werden werden, während im vorbekannten Stand der Technik aufwändig spezielle Teile mit in das Gewebe eingewebt werden mussten.

Insbesondere sind die Leuchtelemente an einem fertigen oder flächig produzierten und vorzugsweise an einem montierten Drahtgewebe anbringbar. Insbesondere können die Leuchtelement an dem montierten Drahtgewebe austauschbar vorgesehe sein, ohne dass eine Demontage nötig wird.

In einer bevorzugten Weiterbildung der Erfindung ist wenigstens ein Teil der Leuchtelemente separat ansteuerbar und insbesondere sind im Wesentlichen alle Leuchtelemente separat ansteuerbar, um auf dem Leuchtgewebe Informationen wieder zu geben oder um unterschiedliche Licht- und/oder Farbmuster darzustellen. Das erfindungsgemäße Leuchtgewebe eignet sich zur Anzeige von Informationen, Fotos, Werbung, Kunst sowie zur Darstellung von Videos oder Fernsehbildern oder visuellen Bildfolgen.

Vorzugsweise weist das Gewebe einen erheblichen Anteil an offener Fläche auf, der größer als 20 % und insbesondere größer als 40 % der gesamten Drahtgewebefläche ist. In bevorzugten Ausgestaltungen liegt der Anteil der offenen Fläche zwischen 55 und 70 % z.B. bei 64 oder 68 %.

Ein solches Leuchtgewebe auf der Fassade eines Gebäudes bietet neben der Möglichkeit der Darstellung von Informationen, Werbung, etc. insbesondere auch Schutz vor Sonneneinstrahlung und Schutz vor Schlagregen, so dass hier mehrere Funktionen vereint werden können.

Insbesondere in südlichen Ländern kann so ein erheblicher Anteil der ein Gebäude aufheizenden Sonnenstrahlung abgehalten werden, während es andererseits den Benutzern oder Bewohnern des Gebäudes ermöglicht wird, durch die Fenster und durch das Leuchtgewebe hindurch die Umgebung wahrzunehmen. Bei einem hohen Anteil an offener Fläche des Leuchtgewebes kann ein nahezu ungestörter Blick auf die Umgebung aus dem Gebäude heraus ermöglicht werden.

Als Material für die Kett- und/oder Schussfäden des Drahtgewebes eignet sich insbesondere Metall und vorzugsweise Stahl, der in rostfreier Ausführung eingesetzt werden kann. Auch der Einsatz von Messing und anderen metallischen und nichtmetallischen Materialien ist möglich.

In bevorzugten Fällen können einige oder einzelne der Fäden mit Kunststoff ummantelt sein, um die entsprechende Fäden gegenüber anderen Fäden z.B. elektrisch zu isolieren.

Es ist auch möglich, dass ein Teil der Drähte aus einem Bündel von Fäden besteht, z.B. als gesponnener Faden oder als Seil oder dergleichen.

Bevorzugt ist auch der Einsatz von Stäben als Kett- und/oder Schussdrähten. Möglich ist es auch, in z.B. horizontaler Richtung Stäbe und in z.B. vertikaler Richtung Drähte oder Seile einzusetzen, die z.B. teilweise oder ganz als gesponnene Fäden vorliegen.

In allen Ausgestaltungen ist der Durchmesser der Drähte grundsätzlich beliebig, liegt aber insbesondere zwischen 0,2 mm und 15 mm. Bevorzugt sind Durchmesser von 0,5 mm bis 5 mm. Möglich ist auch der Einsatz von Rohren mit größeren Durchmessern oder von profilierten Drähten.

Zur Unterstützung der Lichtausgabe können noch Lichtleiter vorgesehen sein, um das von den Leuchtelementen ausgestrahlte Licht zu jeweils einer oder mehreren separaten Lichtaustrittsstellen zu leiten. Lichtleiter können auch eingesetzt werden, um auftretendes Sonnenlicht oder separate Lichtquellen in bestimmte Richtungen umzulenken oder zu bündeln.

In bevorzugten Weiterbildungen der Erfindung ist ein Leuchtelement an einer Stützeinrichtung oder es sind mehrere Leuchtelemente an einer gemeinsamen Stützeinrichtung angeordnet. Dadurch wird die Montage erleichtert, da durch Anbringung der Stützeinrichtung gleichzeitig mehrere Leuchtelemente an dem Drahtgewebe befestigt werden.

Ein weiterer wesentlicher Vorteil ist, dass die Leuchtelemente nicht entlang der Schussrichtung des Drahtgewebes vorgesehen sein müssen, sondern die Leuchtelemente können einzelnen oder jeweils zu mehreren an beliebigen Kett- und/oder Schussdrähten angeordnet werden.

Es ist auch möglich mehrere Leuchtelemente an einer gemeinsamen Stützeinrichtung anzuordnen, die wiederum an beliebigen geeigneten Stellen des Drahtgewebes befestigt werden kann. Die Stützeinrichtung kann insbesondere als lineares und gerade gestaltetes Element vorgesehen sein, die z.B. auch entlang der Schussrichtung ausgerichtet werden kann, aber nicht werden muss.

Möglich ist aber im Gegensatz zum vorbekannten Stand der Technik auch die Ausrichtung in Kettrichtung oder sogar diagonal zum Drahtgewebe. In bestimmten Ausgestaltungen können vorteilhafterweise auch gekrümmte oder über Eck ausgerichtete Stützeinrichtungen angeordnet werden, so dass eine Stützeinrichtung mit gemäß einem vordefinierten Muster angeordneten Leuchtelementen z.B. in Kreis- oder Ringform oder entsprechend einer vorbestimmten Kontur angebracht werden kann.

Um die Transparenz des Leuchtgewebes groß zu halten und/oder um einer Person einen möglichst ungestörten Durchblick durch das Leuchtgewebe zu ermöglichen, werden die Stützeinrichtungen vorzugsweise lichtdurchlässig und insbesondere transparent und farbneutral ausgeführt. Dadurch wird erreicht, dass bei einem Durchblick durch das Drahtgewebe im Wesentlichen nur die Leuchtelemente nicht aber die Stützeinrichtungen wahrgenommen werden.

In bevorzugten Weiterbildungen weist wenigstens eine Stützeinrichtung wenigstens eine Klemmeinrichtung auf, die insbesondere wenigstens einen Klemmhaken oder wenigstens eine Klemmnut oder dergleichen aufweist. Ein z.B. aus Draht gebogener Klemmhaken kann an einem Kett- und/oder Schussdraht drehbar befestigt sein und einen Aufnahmebereich aufweisen, der zur Aufnahme der Stützeinrichtung dient. Am anderen Ende des Klemmhakens kann eine Rasteinrichtung vorgesehen sein, die nach Aufnahme der Stützeinrichtung in dem Aufnahmebereich an einem anderen Kett- und/oder Schussdraht einrastet, um so die Stützeinrichtung an dem Drahtgewebe zu befestigen.

In einer anderen bevorzugten Weiterbildung wird eine Stützeinrichtung eingesetzt, die eine Oberfläche mit einer Edelstahl-Optik aufweist. Insbesondere besteht die Stützeinrichtung aus Edelstahl. In der vorzugsweise etwa U-förmigen Stützeinrichtung in Form einer Schiene sind Leuchtelemente angeordnet, die vorzugsweise auf einer Platine angeordnet sind.

Das verbleibende Volumen der Stützeinrichtung kann mit einem Füllmaterial ausgegossen werden. Vorzugsweise wird ein Füllmaterial verwendet, welches einer Gruppe von Füllmaterialien entnommen ist, die Polyesterharz, Polyuerethanharz, Polyurethanharz, Epoxidharz, Silikonharz, Silikon und Vinylester-' harz und dergleichen umfasst.

Ein erheblicher Vorteil des Einsatzes einer Stützeinrichtung aus Edelstahl ist, dass solche Stützeinrichtungen unabhängig von der Witterung und nahezu unverwüstbar sind.

Die Anordnung der Leuchtelemente direkt auf einer Platine mit einer elektrischen oder elektronischen Schaltung zur Ansteuerung der Leuchtelemente hat den Vorteil der kurzen Wege zwischen Steuerungselektronik und Leuchtelement. Wenn zusätzlich die Leuchtelemente in der Stützeinrichtung mit einem Füllmaterial vergossen werden, ist die Steuerelektronik der Leuchtelemente zuverlässig vor allen Witterungseinflüssen und vor Feuchtigkeit geschützt, die durch Kontaktüberbrückungen an der Steuerelektronik zu einem Fehlverhalten oder zu Beschädigungen der Elektronik führen könnten.

Wird ein transparentes Füllmaterial verwendet, können die Leuchtkörper der einzelnen Leuchtelemente auch vollständig in dem Füllmaterial aufgenommen werden. In all diesen Fällen wird eine kompakte Struktur der mit den Leuchtelementen ausgerüsteten Stützeinrichtungen erzielt. Die Leuchtelemente sind sicher vor Beschädigungen an bzw. in den Stützeinrichtungen aufgenommen.

Vorzugsweise wird ein transparentes Füllmaterial verwendet. Dann können die Leuchtelemente eingegossen werden, sodass die lichtabgebende Oberfläche der Leuchtelemente von der transparenten Füllschicht abgedeckt wird. In einer anderen bevorzugten Ausgestaltung kann ein farbiges und insbesondere dunkles oder auch schwarzes Füllmaterial eingesetzt werden, welches dann nur bis unterhalb des Beginns der lichtabgebenden Oberfläche der Leuchtelemente reicht. In einer weiteren bevorzugten Ausgestaltung sind die Leuchtelemente bis zur Oberkante in einem dunklen Füllmaterial eingebettet und darüber ist eine transparente Deckschicht angeordnet, die aus einer Glasschicht oder Kunststoffschicht oder aus einer weiteren Füllschicht besteht, die transparent ausgeführt ist.

In einer anderen besonders bevorzugten Ausgestaltung ist die Klemmeinrichtung an der Stützeinrichtung verliersicher aufgenommen oder eine oder mehrere Klemmeinrichtungen sind an der Stützeinrichtung befestigt, indem sie z.B. angeschweißt oder angeschraubt sind. Beispielsweise kann die Klemmeinrichtung sich um die im Querschnitt U-förmige Stützeinrichtung herum erstrecken und an beiden Enden jeweils einen Klemmbügel aufweisen. Die Klemmbügel sind dafür vorgesehen, in das Drahtgewebe einzugreifen und einen sicheren Halt der Stützeinrichtungen an dem Drahtgewebe zu erzielen. Dazu können die Klemmbügel jeweils einen Kettdraht oder einen Schussdraht des Drahtgewebes klemmend umgreifen. Bei einer solchen mit Klemmbügeln ausgerüsteten Stützeinrichtung kann die Stützeinrichtung mit den daran aufgenommenen Leuchtelementen insgesamt an das Drahtgewebe angesteckt werden, wobei die Klemmbügel an Kettdrähten oder an Schussdrähten des Drahtgewebes einrasten und die Stützeinrichtung mit den Leuchtelementen sicher aufnehmen.

Solch eine mit verliersicher aufgenommenen Klemmbügeln ausgerüstete Stützeinrichtung ist einfach zu handhaben und zu montieren. Die Klemmbügel können dabei an der Stützeinrichtung angeschraubt oder angeschweißt sein oder die Klemmbügel können einen z.B. rechteckigen Rahmen aufweisen, der auf die Stützeinrichtung aufgeschoben wird, sodass im Betrieb die Klemmbügel fest mit der Stützeinrichtung verbunden sind, aber als separate Teile vor der Montage zunächst auf die Stützeinrichtung aufgeschoben werden, sodass die Stützeinrichtung gemeinsam mit den Klemmbügeln an dem Drahtgewebe angebracht wird oder von diesem gelöst wird.

Alternativ dazu ist es auch möglich, die Stützeinrichtung mittels einer Schraube an dem Drahtgewebe zu befestigen, oder an der Stützeinrichtung eine Klemmnut oder mehrere Klemmnuten vorzusehen, deren Durchmesser an die Kett- und/oder Schussdrähte des Drahtgewebes angepasst ist, um durch Aufschieben der Klemmnut auf die Kett- und/oder Schussdrähte des Drahtgewebes ein Festklemmen der Stützeinrichtung an dem Drahtgewebe zu bewirken.

Alternativ dazu kann die Stützeinrichtung durch magnetische Kräfte oder Klebstoff oder durch einen Rödeldraht an dem Drahtgewebe befestigt werden.

In all diesen Fällen ist der Austausch defekter Komponenten mit wenig Aufwand möglich, da in diesen Fällen die Grundspannung des montierten Drahtgewebes nicht gelöst werden muss, um Leuchtelemente auszutauschen.

In bevorzugten Weiterbildungen der Erfindung umfasst wenigstens ein Leuchtelement wenigstens eine Leuchtdiode. Vorzugsweise weist ein Leuchtelement zwei oder drei oder mehr unterschiedlich farbige Leuchtdioden auf, die vorzugsweise getrennt ansteuerbar sind, um gezielt bestimmte Farbeindrücke hervorzurufen. Alternativ zu dem Einsatz von Leuchtdioden können auch andere Leuchtmittel wie z.B. Glühbirnen, Leuchtstoffelemente oder Halogenlampen etc. eingesetzt werden.

Bevorzugt ist auch der Einsatz von RGB-LED's oder von 3-Chip-Systemen mit Farbausgabe oder von Systemen, bei denen auf einer Platine LED's angeordnet sind. Besonders bevorzugt ist auch der Einsatz von organischen Leuchtdioden.

In einer weiteren bevorzugten Ausgestaltung wird die Energieversorgung für wenigstens ein Leuchtelement über das Drahtgewebe bereitgestellt, in dem einzelne Kett- oder Schussdrähte als Stromleiter dienen. Dazu werden z.B. die Kreuzungspunkte des Drahtgewebes isoliert, um einen Kurzschluss zu verhindern. Möglich ist auch, dass einzelne Drähte hohl ausgebildet sind, so dass im Inneren der entsprechenden hohlen Kett- und/oder Schussdrähte ein oder zwei Leiter für die Stromzuführung vorhanden sein können.

In vorteilhaften Ausgestaltungen können wenigstens einige und insbesondere im Wesentlichen alle Leuchtelemente mit drahtlosen Signalen, insbesondere mit Funk-, Infrarot- oder mit Ultraschallsignalen gesteuert werden. Vorzugsweise ist dann jeweils ein Empfänger für ein oder mehrere Leuchtelemente vorgesehen, der die entsprechenden Funksignale aufnimmt und an die dem Empfänger zugeordneten Leuchtelemente weitergibt.

In bevorzugten Ausgestaltungen der Erfindung beträgt der seitliche Abstand zweier Leuchtelemente zwischen etwa 10 und 250 mm, vorzugsweise zwischen 25 und 75 mm und insbesondere etwa 50 mm. An dieser Stelle sei darauf hingewiesen, dass auch Abweichungen von ± 20 % der genannten Werte möglich sind.

Insbesondere für große Flächen sind auch größere seitliche Abstände von z.B. 1 m oder mehr möglich.

In besonders bevorzugten Ausgestaltungen ist der horizontale Abstand und der vertikale Abstand zweier Leuchtelemente gleich bzw. etwa gleich. Unter einem gleichen Abstand wird hier im Sinne der Erfindung auch ein im Wesentlichen gleicher Abstand verstanden, so dass Abweichungen von ± 20 % möglich und zulässig sind.

In bevorzugten Weiterbildungen ist eine asymmetrische Auflösung in horizontaler und vertikaler Richtung bevorzugt. Es hat sich herausgestellt, dass eine höhere Auflösung in horizontaler Richtung wichtiger ist als in vertikaler Richtung, sodass die Auflösung in horizontaler Richtung vorzugsweise größer als in vertikaler Richtung gewählt wird. Das Verhältnis aus horizontaler und vertikaler Auflösung ist vorzugsweise größer 2 und kann ein Verhältnis von 10 oder 20 aufweisen.

In allen Ausgestaltungen können zusätzliche Lichtleitelemente vorgesehen sein, um das Licht der Leuchtelemente und/oder eingestrahltes Sonnenlicht umzuleiten. Auch das Licht separater Leuchten kann durch die Lichtleitelemente umgeleitet werden.

Vorzugsweise ist wenigstens ein Lichtleitelement steuerbar, um den Lichtdurchtritt durch das Lichtleitelement zu beeinflussen. Beispielsweise können verstellbare transparente oder spiegelnde Lamellen oder Spiegel vorgesehen sein. Es ist auch möglich, dass Flüssigkristallbildschirme bzw. Liquid-Crystal-Displays (LCD-Systeme) oder Flüssigkristallschichten oder dergleichen eingesetzt werden, um die Transparenz einer Schicht gezielt zu beeinflussen. Bevorzugt ist auch der Einsatz von Reflektoren oder Linsen zur Umlenkung oder Bündelung.

In allen Ausgestaltungen kann eine transparente Deckschicht vorgesehen sein, die aus Glas wie z.B. Floatglas oder sonstigen Glassorten bestehen kann. Möglich ist auch der Einsatz von Kunststoffgläsern wie z.B. Acrylglas. Das Deckglas kann als opakes Weißglas ausgeführt und z.B. satiniert ausgeführt sein, um eine homogenere Lichtverteilung zu erzielen. Zwar wird durch die Satinierung des Glases die Intensität des ausgestrahlten Lichtes um z.B. 10 oder 15 % verringert, aber dafür wird eine homogenere Ausleuchtung erzielt und es werden Moiree-Effekte verhindert, was die Betrachtungsqualität erheblich erhöht.

In bevorzugten Weiterbildungen der Erfindung ist der Abstand der Kett- und der Schussdrähte unterschiedlich, wobei die Dicke der Kett- und der Schussdrähte ähnlich oder sogar gleich sein kann.

Bei dem erfindungsgemäßen Leuchtgewebe bzw. bei der erfindungsgemäßen Leuchteinheit kann statt eines Drahtgewebes auch ein Drahtgeflecht, Drahtgewirk oder ein Drahtnetz eingesetzt werden, an dem die Leuchtelemente angeordnet sind.

Die Erfindung ist auch auf ein transparentes Fassadenelement ausgerichtet, das eine transparente Trägereinheit und Leuchtelemente umfasst, wobei die Leuchtelemente separat an der Trägereinheit angeordnet sind, so dass eine Nachrüstung bestehender Fassadenelemente mit Trägereinheiten mit Leuchtelementen möglich ist.

Vorzugsweise ist die Trägereinheit ein Drahtgewebe, kann aber auch als ein Drahtgewirk, ein Drahtgeflecht oder ein Drahtnetz oder gegebenenfalls als ein Lochblech ausgebildet sein.

Vorzugsweise ist bei einem transparenten Fassadenelement ein Abstand von zwei vertikal ausgerichteten Drähten zueinander größer als ein Abstand zweier horizontal ausgerichteter Drähte zueinander.

Vorzugsweise sind bei dem transparenten Fassadenelement Gruppen von zwei, drei, vier oder fünf vertikalen Drähten vorgesehen, wobei in jeder Gruppe die Drähte dicht zueinander benachbart angeordnet sind, während der Abstand von einer Gruppe zur benachbarten Gruppe erheblich größer ist, als der Drahtabstand innerhalb einer Gruppe.

Bei dem erfindungsgemäßen Verfahren zur Nachrüstung eines Drahtgewebes mit Leuchtelementen werden die Leuchtelement in Reihen und Spalten auf das fertige großflächige Drahtgewebe die Leuchtelemente z.B. von hinten aufgebracht und dort befestigt. Dabei sind mehrere Leuchtelemente an einer Stützeinrichtung vorgesehen, welche dann an dem Drahtgewebe angebracht wird.

Die Leuchtelemente können einzeln aufgebracht werden oder sie können an einer separaten Stützeinrichtung vormontiert sein, welche dann an dem Drahtgewebe angebracht wird. Das Verfahren zum Nachrüsten eignet sich auch in identischer Weise zur Herstellung eines Leuchtgewebes.
- Fig. 1: eine Vorderansicht eines Leuchtgewebes gemäß der vorliegenden Erfindung zur Anwendung im Architekturbereich;
- Fig. 2: einen vergrößerten Ausschnitt der Vorderansicht des Leuchtgewebes nach Fig. 1;
- Fig. 3: eine Seitenansicht des Leuchtgewebes nach Fig. 2;
- Fig. 4: einen Klemmhaken des Leuchtgewebes nach Fig. 2;
- Fig. 4a: einen weiteren Klemmhaken für ein Leuchtgewebe nach Fig. 2;
- Fig. 5: eine Seitenansicht eines weiteren erfindungsgemäßen Leuchtgewebes;
- Fig. 6: eine Schraubklemme zur Befestigung der Leuchtelemente an dem Leuchtgewebe nach Fig. 5;
- Fig. 7: eine Seitenansicht eines dritten erfindungsgemäßen Leuchtgewebes;
- Fig. 8: eine Seitenansicht eines vierten erfindungsgemäßen Leuchtgewebes;
- Fig. 9: eine Vorderansicht eines fünften erfindungsgemäßen Leuchtgewebes;
- Fig. 10: eine Seitenansicht des Leuchtgewebes nach Fig. 9;
- Fig. 11: eine Seitenansicht eines weiteren Leuchtgewebes mit anderen Klemmeinrichtungen; und

- Fig. 12: einen Querschnitt einer Stützeinrichtung.

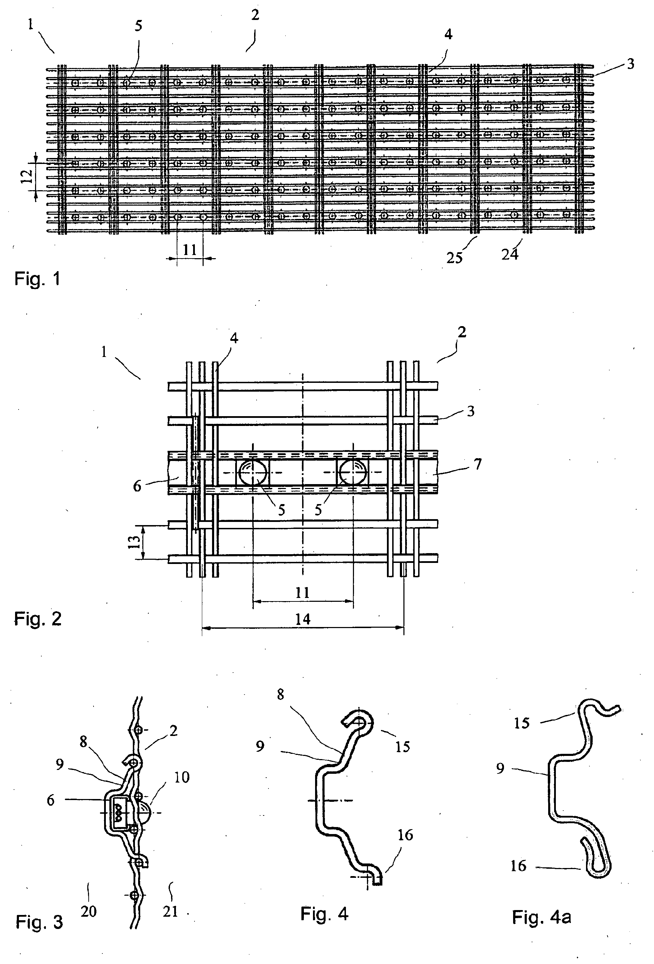

In den Figuren 1 bis 4 ist ein erstes Ausführungsbeispiel des erfindungsgemäßen Leuchtgewebes 1 dargestellt. In Figur 1 ist ein Abschnitt einer Vorderansicht eines Leuchtgewebes dargestellt, dass an einem Drahtgewebe 2 angeordnete Leuchtelemente 5 umfasst. Das Drahtgewebe 2 weist Schussdrähte 3 und senkrecht dazu ausgerichtete Kettdrähte 4 auf.

Im vorliegenden Ausführungsbeispiel bilden drei Kettdrähte 4 jeweils eine Gruppe von Kettdrähten 24 bzw. 25. Innerhalb der einzelnen Gruppen 24, 25 ist der seitliche Abstand der einzelnen Kettdrähte sehr gering und nur etwas größer als der Drahtdurchmesser der Kettdrähte, während der seitliche Abstand von einer Gruppe 24 zur nächsten Gruppe 25 erheblich größer ist und hier im Ausführungsbeispiel mehr als das 10-fache beträgt. Unter anderem dadurch wird ein hoher offener Anteil des Leuchtgewebes erzielt, so dass ein nur wenig gestörter Durchblick durch das Leuchtgewebe 1 möglich ist.

Hier im Ausführungsbeispiel ist der horizontale Abstand 11 der einzelnen Leuchtelemente etwa gleich dem vertikalen Abstand 12 zweier Leuchtelemente und die Leuchtelemente sind insgesamt etwa äquidistant über der Fläche des Leuchtgewebes 1 angeordnet. Durch die äquidistante Anordnung der Leuchtelemente eignet sich das Leuchtgewebe 1 gut zur Darstellung geometrischer Bilder oder auch von unbeweglichen oder bewegten Bilder oder Figuren, sowie von Fotos oder auch von Videos. Auch eine asymmetrische Auflösung ist möglich, wobei die horizontale Auflösung vorzugsweise höher ist als die vertikale Auflösung.

Der Abstand der Leuchtelemente 5 beträgt hier etwa 50 mm, kann aber in anderen Ausgestaltungen auch 25 mm, 50 mm, 100 mm oder 200 mm (etwa 8 Zoll) betragen. Bei dem hier vorliegenden Abstand von 50 mm (etwa 2 Zoll) wird eine Auflösung von 320 x 240 Bildpunkten bei einer Gewebegröße von 16 m x 12 m erreicht und eine VGA-Auflösung von 640 x 480 Bildpunkten bei einer Gewebegröße von 32 m x 24 m. Solche Fläche stehen an vielen Fassaden von Gewerbegebäuden oder von Hochhäusern zur Verfügung, so dass einer breiter Einsatz möglich ist. Möglich ist auch eine Videoleinwand in Stadien oder auf öffentlichen Plätzen oder dergleichen, die bei sportlichen oder sonstigen Großereignissen zur Bildübertragung verwendet werden können.

Die einzelnen Leuchtelemente 5 sind im Ausführungsbeispiel nach den Figuren 1 - 4 an einer als Schiene 7 ausgeführten Stützeinrichtung 6 montiert. Die Schiene 7 wird mittels einer als Befestigungshaken 9 ausgeführten Klemmeinrichtung 8 an dem Drahtgewebe 2 befestigt. Dazu ist das eine Ende 15 des Befestigungshakens 9 an einem Schussdraht 3 verschwenkbar befestigt und das andere Ende 16 des Befestigungshakens 9 wird an einem anderen Schussdraht 3 des Drahtgewebes 2 festgeklemmt, während die Schiene 7 in einem Aufnahmebereich des Befestigungshakens 9 aufgenommen und dort an das Leuchtgewebe 1 angeklemmt wird.

In Fig. 4a ist eine Variante des Hakens 9 dargestellt, der am Ende 16 am Gewebe eingehakt und mit dem anderen Ende 15 am Gewebe eingerastet wird, um die Stützeinrichtung 6 zu befestigen.

Die Schiene 7 mit den Leuchtelementen 5 ist auf der Rückseite des Drahtgewebes 2 montiert. Die einzelnen Leuchtelemente ragen teilweise durch offene Stellen in dem Drahtgewebe 2 hindurch. Dadurch liegt ein guter Schutz der Leuchtelemente 5 vor äußeren Einflüssen wie Hagel oder Vandalismus vor, insbesondere wenn die Leuchtelemente noch weiter zurückgezogen montiert werden als es in Fig. 3 dargestellt ist. In speziellen Ausgestaltungen kann noch eine separate Jalousie oder Rollade vorgesehen sein, die die Beleuchtungselemente und das Leuchtgewebe bei Nichtgebrauch schützt.

Das erfindungsgemäße Leuchtgewebe 1 eignet sich für den Einsatz innen und außen. Beispielsweise kann eine Innenwand mit einem großflächigen Leuchtgewebe versehen sein, welches im Leuchtbetrieb ein Fernsehbild zeigt, während es ohne Licht als hochqualitative Wandverkleidung dienen kann. In Weiterbildungen können auch kleinere elektronische Leuchtelemente eingesetzt werden, so dass eine höhere Dichte der Leuchtpunkte erzielbar ist.

Wird das Leuchtgewebe 1 als transparentes Fassadenelement 1 eingesetzt, wird es hauptsächlich im Außenbereich eingesetzt.

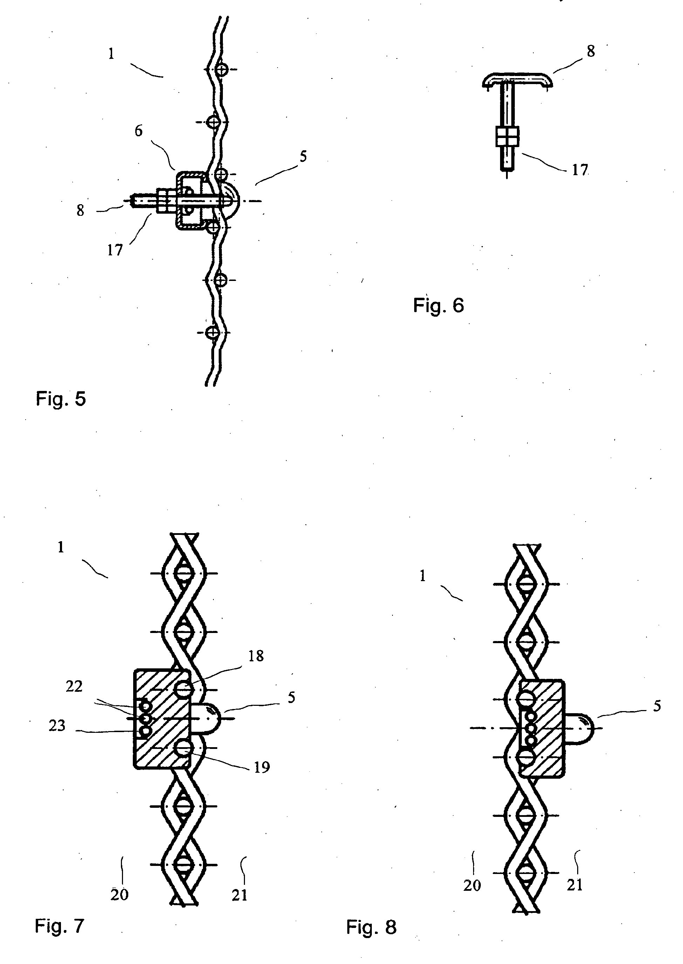

Eine Aufsicht auf das Ausführungsbeispiel nach den Figuren 5 und 6 entspricht im Wesentlichen der Aufsicht auf die Figur 1, so dass bei der Erörterung der in Figuren 5 und 6 dargestellten Variante nur auf die Unterschiede zu dem vorigen Ausführungsbeispiel eingegangen wird. Bei der in Figur 5 dargestellten Seitenansicht eines Leuchtgewebes 1 sind die Leuchtelemente 5 ebenfalls in einer Stützeinrichtung 6 aufgenommen, die ebenfalls als Schiene 7 ausgeführt sein kann.

Im Unterschied zum vorherigen Ausführungsbeispiel wird zur Befertigung der Stützeinrichtung 6 an dem Leuchtgewebe 1 eine Klemmeinrichtung 8 mit einem Gewinde 17 eingesetzt. Zur Befestigung wird die Stützeinrichtung 6 mit dem Klemmbügel der Klemmeinrichtung 8 an dem Gewebe festgeklemmt.

Bei der in Figur 7 dargestellten Variante umfasst das Stützelement 6 Klemmnuten 18 und 19, die auf Schuss- oder Kettdrähte des Drahtgewebes aufgeschoben und damit verklemmt werden. Auch bei dieser Befestigungsmöglichkeit wird ein sicherer Sitz der Stützeinrichtung 6 bzw. der Beleuchtungselemente 5 an dem Drahtgewebe erzielt. Der Durchmesser der Klemmnuten 18 und 19 wird an die Durchmesser der Drähte (Schussdrähte, Kettdrähte) angepasst.

Auf der Rückseite der Stützeinrichtung 6 aus Figur 7 sind drei Leitungen erkennbar. In diesem speziellen Fall dienen zwei der drei Leitungen als Stromversorgung. Die dritte Leitung dient zusammen mit der Masse der Stromversorgung als Datenleitung. Die Datenkommunikation kann als Bussystem, insbesondere als autoadressierbare Reihenschaltung umgesetzt werden. Es ist auch eine getrennte konventionelle Verdrahtung jedes einzelnen Leuchtelements möglich.

In einer weiteren Ausgestaltung des Systems können eine oder mehrere Leuchtelemente, die jeweils eine oder mehrere Farben ausstrahlen können, auf einer gemeinsamen Platine plaziert werden. Diese Platinen werden dann mit einem vier LeitungsSystem untereinander und mit der Steuerung verbunden. Wobei in diesem Fall zwei Leitungen für die Stromversorgung dienen und zwei Leitungen als Datenleitungen genutzt werden.

Beide Systeme können auch als 2-Leitersysteme ausgeführt werden, bei dem auf den Leitern zu Energieübertragung auch noch Datensignale aufmoduliert werden. Die Datenkommunikation kann auch mittels Lichtleitern stattfinden.
In einer weiteren bevorzugten Ausgestaltung erfolgt die Ansteuerung und/oder die Energieversorgung wenigstens eines Leuchtelementes oder mehrerer Leuchtelemente über separate Leitungen, wobei die Leuchtelemente insbesondere über ein Bussystem miteinander verbunden sind.

Bei dem in Figur 7 dargestellten Ausführungsbeispiel ist die Stützeinrichtung auf der Rückseite 20 des Drahtgewebes 2 des Leuchtgewebes 1 vorgesehen und das Leuchtelement 5 ragt durch das Drahtgewebe hindurch, sodass die Leuchtelemente 5 bis zur Vorderseite 21 des Drahtgewebes durchragen. Von vorn gesehen fallen die in den transparenten Schienen 7 angeordneten Leuchtelemente 5 im abgeschalteten Zustand kaum auf.

Das in einer Seitenansicht in Figur 8 gezeigte Ausführungsbeispiel zeigt ein Drahtgewebe 1, bei dem die Stützeinrichtung 6 nicht auf der Rückseite 20 des Leuchtgewebes 1 sondern auf der Vorderseite 21 des Leuchtgewebes 1 vorgesehen ist. Auch bei diesem Ausführungsbeispiel wird die Schiene bzw. die Stützeinrichtung 6 auf Drähte des Drahtgewebes aufgesteckt bzw. aufgeclipst.

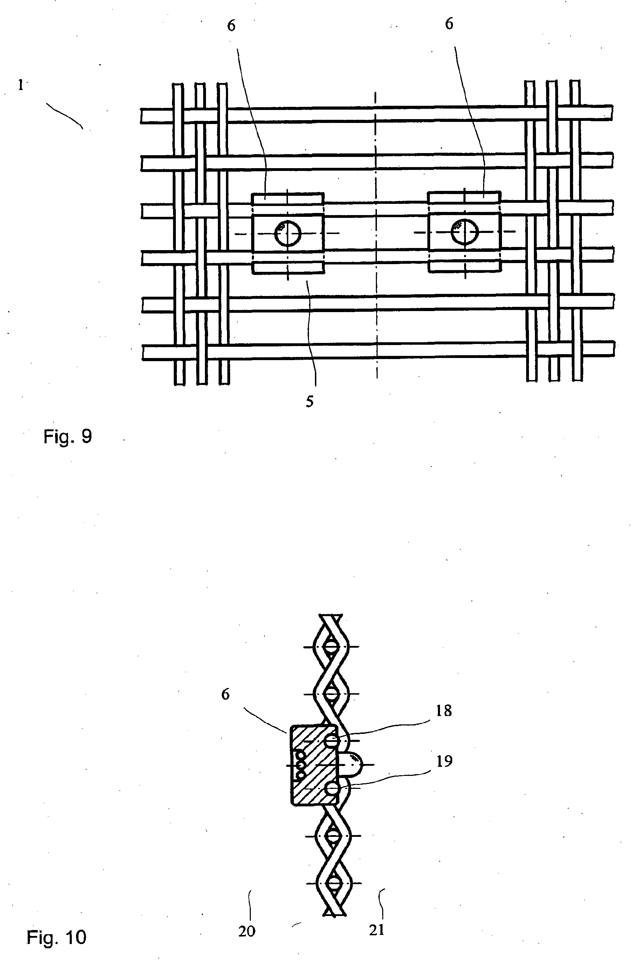

Bei dem in den Figuren 9 und 10 dargestellten Ausführungsbeispiel verfügt jedes einzelne Leuchtelement 5 über eine separate Stützeinrichtung 6, die dann an die Schuss- bzw. Kettdrähte des Drahtgewebes angebracht werden, indem die Stützeinrichtung mit den Befestigungsnuten 18 und 19 an die Drähte des Leuchtgewebes 1 angeklemmt wird.

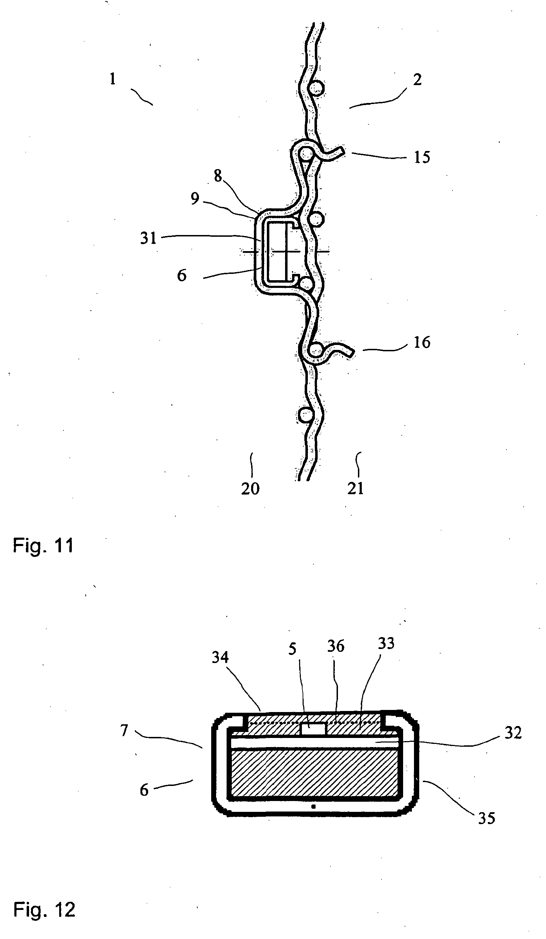

In Fig. 11 ist ein weiteres Ausführungsbeispiel in einer Seitenansicht gezeigt. Auf der Rückseite 20 eines Leuchtgewebes 1 ist eine hier als U-förmige Profilschiene ausgeführte Stützeinrichtung 6 an dem Leuchtgewebe 1 vorgesehen. Die Schiene 6 liegt an dem Drahtgewebe 2 an und erstreckt sich über die Breite eines oder mehrerer Drahtgewebesegmente, die typischerweise eine Gewebebreite zwischen etwa 50 cm und 10 m aufweisen.

Auch in diesem Ausführungsbeispiel ist die Stützeinrichtung 6 über eine als Klemmbügel oder Haken 9 ausgeführte Klemmeinrichtung 8 an mehreren Stellen an dem Drahtgewebe 2 gehalten. Hier sind beide Enden 15 und 16 des Befestigungshakens 9 gleich gestaltet. Zur Montage wird die Schiene 7 an die vorgesehene Stelle an dem Drahtgewebe 2 gehalten, und es werden in vorbestimmten Abständen die Haken 9 über die Schiene 7 gesteckt und an das Drahtgewebe 2 angeclipst, sodass sich eine feste Verbindung zwischen der Schiene 7 und dem Drahtgewebe 2 ergibt.

In einer weiteren Ausgestaltung werden die Haken 9 in vorbestimmten Abständen von z.B. 30 cm oder 50 cm oder dergleichen an die Schiene 7 fest angebracht, sodass die gesamte Schiene 7 mit den Haken 9 auf das Drahtgewebe aufgesteckt bzw. angeclipst wird.

Ein Vorteil einer solchen Ausgestaltung ist, dass zur Montage nur die Schiene 7 verwendet werden muss, da die Haken 9 schon an der Schiene integriert sind. In beiden zuvor beschriebenen Fällen kann durch ein einfaches Aufstecken der Schienen von dem Drahtgewebe 2 ein normales Drahtgewebe an einer Fassade in ein Leuchtgewebe umgewandelt werden oder es wird durch ein Abziehen der Schienen ein Leuchtgewebe in ein normales Drahtgewebe umgewandelt.

Eine weitere mögliche Ausgestaltung der Schiene 7 zeigt Fig. 12 im Querschnitt. In das Ü-förmige Profil der Schiene 7 ist eine Platine 32 eingeführt, die sich in der Darstellung nach Fig. 12 etwa über der gesamten freien Breite zwischen den U-Schenkeln des U-Profils erstreckt. Möglich ist auch eine geringere Breite.

Auf der Platine 32 sind die zur Steuerung der Leuchtelemente 5 vorgesehenen Schaltungen enthalten und die Leuchtelemente 5 sind in vorbestimmten Abständen angeordnet. So bildet die Platine 32 eine kompakte Einheit, die in der Schiene 7 gut geschützt aufgenommen ist. Zum Schutz vor Feuchtigkeit und mechanischen Einflüssen ist das verbleibende Volumen in der Schiene durch ein Füllmaterial 33 ausgefüllt, welches hier im Ausführungsbeispiel aus unterschiedlichen Materialien bestehen kann und z.B. ein Arcylharz- oder oder Silikonwerkstoff sein kann.

Die äußere Oberfläche 35 der Schiene 7 weist insbesondere das Aussehen von Edelstahl auf. Vorzugsweise besteht die Schiene 7 aus Edelstahl, um eine hohe Stabilität und ein einheitliches Erscheinungsbild mit dem ebenfalls vorzugsweise aus Edelstahl bestehenden Drahtgewebe 2 zu erzeugen. Durch die Verwendung von Edelstahlschienen fügen sich die Stützeinrichtungen perfekt an das Drahtgewebe an.

Die punktierte Linie 36 zeigt in Fig. 12 die Lage einer möglichen Deckschicht an, die als separate Lage aus Glas oder Kunststoff ausgeführt sein kann. Auch eine obere Lage aus einem durchsichtigen Füllmaterial ist möglich und bevorzugt, während die untere Schicht aus dunklem oder schwarzem Füllmaterial bestehen kann.

## Patentansprüche

1. Leuchtgewebe (1) mit wenigstens einem Drahtgewebe (2) und mit Leuchtelementen (5), wobei das Drahtgewebe Schuss- (3) und Kettdrähte (4) umfasst, wobei die Leuchtelemente (5) in Reihen und Spalten an dem Drahtgewebe (2) vorgesehen und so angeordnet sind, dass die Leuchtelemente (5) an einem fertig montierten Drahtgewebe (2) anbringbar sind, wobei wenigstens zwei der Leuchtelemente (5) an einer Stützeinrichtung (6) befestigt sind und mit der Stützeinrichtung (6) an dem Drahtgewebe (2) befestigt sind, wobei wenigstens die Mehrzahl der Leuchtelemente (5) separat ansteuerbar ist, um visuelle Bildfolgen auf dem Drahtgewebe (2) auszugeben,
**dadurch gekennzeichnet, dass** die Stützeinrichtung (6) eine Schiene (7) umfasst.

2. Leuchtgewebe (1) nach dem vorhergehenden Anspruch, wobei die Stützeinrichtung (6) transparent ausgeführt ist.

3. Leuchtgewebe nach Anspruch 1 oder 2, wobei die Leuchtelemente auf einer Platine angeordnet sind, die von der Schiene aufgenommen ist.

4. Leuchtgewebe nach dem vorhergehenden Anspruch, wobei die Platine in der Schiene mit einem Füllmaterial eingegossen ist.

5. Leuchtgewebe (1) nach einem der vorhergehenden Ansprüche, wobei die Stützeinrichtung (6) wenigstens eine Klemmeinrichtung (8) umfasst, welche wenigstens einen Haken (9) aufweist.

6. Leuchtgewebe nach dem vorhergehenden Anspruch, wobei der Haken (9) verliersicher mit der Stützeinrichtung verbunden ist.

7. Leuchtgewebe (1) nach einem der Ansprüche 1 bis 4, wobei die Stützeinrichtung (6) wenigstens eine Klemmeinrichtung (8) umfasst, welche wenigstens eine Klemmnut aufweist.

8. Leuchtgewebe (1) nach einem der vorhergehenden Ansprüche, wobei die Leuchtelemente (5) oder die Stützeinrichtung (6) an dem Drahtgewebe (2) durch Klemmen, Schrauben, Kleben, magnetische Kräfte, Anstecken oder mit einem Clip befestigt sind.

9. Leuchtgewebe (1) nach einem der vorhergehenden Ansprüche, wobei wenigstens ein Leuchtelement (5) wenigstens zwei oder drei Leuchteinheiten unterschiedlicher Farbcharakteristika umfasst, oder wobei die Farbcharakteristik des Leuchtelements (5) einstellbar ist.

10. Leuchtgewebe (1) nach einem der vorhergehenden Ansprüche, wobei die Ansteuerung und/oder die Energieversorgung wenigstens eines Leuchtelementes (5) über das Drahtgewebe (2) bereitgestellt wird.

11. Leuchtgewebe (1) nach einem der vorhergehenden Ansprüche, wobei die Ansteuerung und/oder die Energieversorgung wenigstens eines Leuchtelementes (5) über separate Leitungen erfolgt, wobei die Leuchtelemente (5) insbesondere über ein Bussystem miteinander verbunden sind.

12. Leuchtgewebe (1) nach einem der vorhergehenden Ansprüche, wobei der seitliche Abstand zweier Leuchtelemente (5) zwischen 25 mm und 500 mm, insbesondere etwa 50 mm beträgt.

13. Verfahren zur Nachrüstung eines Drahtgewebes (2) mit Leuchtelementen (5), wobei die Leuchtelemente (5) in Reihen und Spalten auf das fertige großflächige Drahtgewebe (2) aufgebracht und dort befestigt werden, wobei mehrere Leuchtelemente (5) an einer eine Schiene (7) umfassenden Stützeinrichtung (6) befestigt werden, welche dann an dem Drahtgewebe (2) befestigt wird, um visuelle Bildfolgen auf dem Drahtgewebe auszugeben.

14. Verfahren nach Anspruch 13, wobei die Stützeinrichtung (6) angeclipst wird.

## Claims

1. A luminous mesh (1) comprising at least one wire mesh (2) and luminous elements (5), the wire mesh comprising weft (3) and warp wires (4), the luminous elements (5) being provided on the wire mesh (2) in rows and columns and arranged such that the luminous elements (5) can be attached to a prefabricated wire mesh (2) wherein at least two of the luminous elements (5) are fastened to a support (6) and fastened to the wire mesh (2) together with the support (6), wherein at least the majority of the luminous elements (5) can be controlled individually to output visual image sequences on the wire mesh (2), **characterized in that** the support (6) comprises a rail (7).

2. The luminous mesh (1) according to the preceding claim, wherein the support (6) is configured to be transparent.

3. The luminous mesh according to claim 1 or 2 wherein the luminous elements are disposed on a printed circuit board which is received on the rail.

4. The luminous mesh according to the preceding claim wherein the printed circuit board in the rail is cast into and embedded in a filler material.

5. The luminous mesh (1) according to any of the preceding claims wherein the support (6) comprises at least one clamping means (8) which comprises at least one hook (9).

6. The luminous mesh according to the preceding claim wherein the hook (9) is connected with the support to be loss-proof.

7. The luminous mesh (1) according to any of the claims 1 to 4 wherein the support (6) comprises at least one clamping means (8) which comprises at least one clamping groove.

8. The luminous mesh (1) according to any of the preceding claims wherein the luminous elements (5) or the support (6) are secured to the wire mesh (2) by clamping, screwing, gluing, magnetic forces, or are pushed or clipped on.

9. The luminous mesh (1) according to any of the preceding claims wherein at least one luminous element (5) comprises two or three luminous units of different color characteristics, or wherein the color characteristics of the luminous element (5) can be set.

10. The luminous mesh (1) according to any of the preceding claims wherein control and/or power supply of at least one luminous element (5) is provided through the wire mesh (2).

11. The luminous mesh (1) according to any of the preceding claims wherein control and/or power supply of at least one luminous element (5) occurs through separate lines with the luminous elements (5) interconnected in particular through a bus system.

12. The luminous mesh (1) according to any of the preceding claims wherein the lateral distance of two luminous elements (5) is between 25 mm and 500 mm, in particular approximately 50 mm.

13. A method of retrofitting a wire mesh (2) with luminous elements (5) wherein the luminous elements (5) are attached in rows and columns on the prefabricated large wire mesh panel (2) and fastened thereon wherein multiple luminous elements (5) are attached to a support (6) comprising a rail (7) which is then attached to the wire mesh (2) to output visual image sequences on the wire mesh.

14. The method according to claim 13 wherein the support (6) is clipped on.

## Revendications

1. Tissu lumineux (1) comprenant au moins une toile métallique (2) et des éléments lumineux (5), ladite toile métallique comprenant des fils de trame (3) et de chaîne (4), les éléments lumineux (5) étant prévus en rangées et colonnes sur la toile métallique (2) et étant agencés de telle manière que les éléments lumineux (5) peuvent être montés sur une toile métallique (2) complètement montée, dans lequel au moins deux des éléments lumineux (5) sont fixés sur un dispositif de support (6) et sont fixés avec ledit dispositif de support (6) sur la toile métallique (2), dans lequel au moins la plupart des éléments lumineux (5) peut être commandée de manière séparée afin d'émettre des séquences visuelles d'images sur la toile métallique (2), **caractérisé par le fait que** ledit dispositif de support (6) comprend un rail (7).

2. Tissu lumineux (1) selon la revendication précédente, dans lequel ledit dispositif de support (6) est réalisé de manière transparente.

3. Tissu lumineux selon la revendication 1 ou 2, dans lequel les éléments lumineux sont disposés sur une carte qui est reçue par le rail.

4. Tissu lumineux selon la revendication précédente, dans lequel ladite carte est scellée à un matériau de remplissage dans le rail.

5. Tissu lumineux (1) selon l'une quelconque des revendications précédentes, dans lequel ledit dispositif de support (6) comprend au moins un dispositif de serrage (8) qui présente au moins un crochet (9).

6. Tissu lumineux selon la revendication précédente, dans lequel ledit crochet (9) est relié d'une manière imperdable au dispositif de support.

7. Tissu lumineux (1) selon l'une quelconque des revendications 1 à 4, dans lequel le dispositif de support (6) comprend au moins un dispositif de serrage (8) qui présente au moins une rainure de serrage.

8. Tissu lumineux (1) selon l'une quelconque des revendications précédentes, dans lequel les éléments lumineux (5) ou le dispositif de support (6) sont fixés sur la toile métallique (2) par serrage, vissage, collage, par des forces magnétiques, en le(s) rapportant ou par le biais d'un clip.

9. Tissu lumineux (1) selon l'une quelconque des revendications précédentes, dans lequel au moins un élément lumineux (5) comprend au moins deux ou trois unités lumineuses de caractéristiques de couleur différentes, ou dans lequel la caractéristique de couleur de l'élément lumineux (5) est réglable.

10. Tissu lumineux (1) selon l'une quelconque des revendications précédentes, dans lequel la commande et/ou l'alimentation en énergie d'au moins un élément lumineux (5) est fournie par la toile métallique (2).

11. Tissu lumineux (1) selon l'une quelconque des revendications précédentes, dans lequel la commande et/ou l'alimentation en énergie d'au moins un élément lumineux (5) se fait via des lignes séparées, les éléments lumineux (5) étant reliés les uns aux autres en particulier par un système de bus.

12. Tissu lumineux (1) selon l'une quelconque des revendications précédentes, dans lequel la distance latérale de deux éléments lumineux (5) est comprise entre 25 mm et 500 mm, en particulier est de 50 mm à peu près.

13. Procédé destiné à équiper ultérieurement une toile métallique (2) d'éléments lumineux (5), dans lequel les éléments lumineux (5) sont appliqués en rangées et colonnes sur la toile métallique (2) finie de grande surface et y sont fixés, dans lequel plusieurs éléments lumineux (5) sont fixés sur un dispositif de support (6) qui comprend un rail (7) et qui est fixé ensuite sur la toile métallique (2) afin d'émettre des séquences visuelles d'images sur la toile métallique.

14. Procédé selon la revendication 13, dans lequel le dispositif de support (6) est monté par clipsage.
